(19) Europäisches Patentamt
European Patent Office
Office européen des brevets

(11) **EP 3 573 103 B1**

(12) **EUROPEAN PATENT SPECIFICATION**

(45) Date of publication and mention
of the grant of the patent:
**06.01.2021 Bulletin 2021/01**

(51) Int Cl.:
*H01L 27/14* (2006.01)   *H01S 5/183* (2006.01)
*H01L 31/0232* (2014.01)   *H01L 27/146* (2006.01)
*H01L 31/102* (2006.01)

(21) Application number: **17894717.2**

(22) Date of filing: **03.02.2017**

(86) International application number:
**PCT/CN2017/072849**

(87) International publication number:
**WO 2018/141083 (09.08.2018 Gazette 2018/32)**

(54) **PHOTOELECTRIC CONVERSION APPARATUS**

FOTOELEKTRISCHE UMWANDLUNGSVORRICHTUNG

APPAREIL DE CONVERSION PHOTOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.11.2019 Bulletin 2019/48**

(73) Proprietor: **Huawei Technologies Co., Ltd.
Longgang District
Shenzhen, Guangdong 518129 (CN)**

(72) Inventors:
• **HU, Jing**
**Shenzhen**
**Guangdong 518129 (CN)**
• **WANG, Heng**
**Shenzhen**
**Guangdong 518129 (CN)**
• **GONG, Jianmin**
**Shenzhen**
**Guangdong 518129 (CN)**
• **WU, Xuming**
**Shenzhen**
**Guangdong 518129 (CN)**
• **CHEN, Jian**
**Shenzhen**
**Guangdong 518129 (CN)**
• **LI, Shengping**
**Shenzhen**
**Guangdong 518129 (CN)**

(74) Representative: **Isarpatent
Patent- und Rechtsanwälte Behnisch Barth
Charles
Hassa Peckmann & Partner mbB
Friedrichstrasse 31
80801 München (DE)**

(56) References cited:
**CN-A- 1 328 347**   **CN-A- 1 780 004**
**CN-A- 1 950 781**   **CN-A- 101 876 732**
**CN-U- 202 145 301**   **KR-A- 20050 086 042**
**US-A- 5 389 797**   **US-A1- 2005 012 106**
**US-A1- 2005 230 722**

• **YUYU XIA ET AL: "A vertical cavity
semiconductor optical amplifier monolithically
integrated with the photodetector", ASIA
COMMUNICATIONS AND PHOTONICS
CONFERENCE 2016, 1 January 2016
(2016-01-01), page AS1F.7, XP055640218,
Washington, D.C. DOI:
10.1364/ACPC.2016.AS1F.7 ISBN:
978-0-9600380-0-8**
• **LEWEN R ET AL: "Experimental demonstration
of a multifunctional long-wavelength
vertical-cavity laser amplifier-detector", IEEE
PHOTONICS TECHNOLOGY LETTERS, IEEE
SERVICE CENTER, PISCATAWAY, NJ, US, vol.
10, no. 8, 1 August 1998 (1998-08-01) , pages
1067-1069, XP011431530, ISSN: 1041-1135, DOI:
10.1109/68.701504**

**Description**

**TECHNICAL FIELD**

This application relates to the communications field, and in particular, to an optical-to-electrical conversion apparatus in the communications field.

**BACKGROUND**

As requirements increase and technologies develop, a data transmission rate on a passive optical network (Passive Optical Network, PON) is increasingly high. Latest standards of two branches, namely, a gigabit passive optical network (Gigabit Passive Optical Network, GPON) and an Ethernet passive optical network (Ethernet Passive Optical Network, EPON), of a passive optical network system are respectively a time and wavelength division multiplexing-passive optical network (Time and Wavelength Division Multiplexing-Passive Optical Network, TWDM-PON) and a next-generation Ethernet passive optical network (Next-Generation Ethernet Passive Optical Network, NGEPON). Single-wavelength rates of the TWDM-PON and the NGEPON reach 10 Gbps and 25 Gbps respectively. The high rates result in a decrease in receiving sensitivity of a receiver and an increase in dispersion costs.

To resolve this problem, receiving sensitivity of a receiver needs to be improved on a component level.

Document "A vertical cavity semiconductor optical amplifier monolithically integrated with the photodetector", Asia Communications and Photonics Conference 2016, page AS1F.7, Yuyu Xia et Al. describes a photodetector integrated with a vertical cavity optical amplifier.

Patent document US20050230722 describes a laser or an optical amplifier integrated with a photodetector.

Document "Experimental demonstration of a multifunctional long-wavelength vertical cavity laser amplifier detector", IEEE Photonics Technology Letters, vol. 10 no. 8 (1998), Lewen et Al. describes a vertical device with an active layer which can be used as an amplifying layer or a light conversion layer.

**SUMMARY**

This application provides an optical-to-electrical conversion apparatus, an optical line terminal, and a passive optical network PON system, to improve receiver sensitivity of the optical-to-electrical conversion apparatus, thereby overcoming impact of a high rate on signal receiving sensitivity.

According to a first aspect, an optical-to-electrical conversion apparatus is provided, including a first reflection layer, an optical gain layer, a light absorption layer, a second reflection layer, a first current source interface, a second current source interface, a first voltage source interface, and a second voltage source interface, where

the first reflection layer and the second reflection layer are disposed in parallel to form a resonant cavity between the first reflection layer and the second reflection layer; signal light is incident from the first reflection layer; after the signal light passes through the first reflection layer, signal light of a transmitted part is output to the resonant cavity; and the signal light of the transmitted part is reflected for a plurality of times between the first reflection layer and the second reflection layer, until the signal light in the resonant cavity is converted into a light current; the optical gain layer and the light absorption layer are located in the resonant cavity;
the optical gain layer is configured to amplify the signal light in the resonant cavity;
the light absorption layer is configured to convert the signal light in the resonant cavity into the light current;
the first current source interface and the second current source interface are respectively connected to a positive electrode and a negative electrode of a current source, to supply a current to the optical gain layer; and
the first voltage source interface and the second voltage source interface are respectively connected to a positive electrode and a negative electrode of a voltage source, to supply voltage to the light absorption layer.

Optionally, the optical gain layer can operate only after being supplied with the current, and the light absorption layer can operate only after being supplied with the voltage.

Optionally, the first current source interface, the second current source interface, the first voltage source interface, and the second voltage source interface may be of a layered structure like the optical gain layer or the light absorption layer.

Optionally, the first current source interface, the second current source interface, the first voltage source interface, and the second voltage source interface have no impact on the signal light.

Therefore, according to the optical-to-electrical conversion apparatus in this embodiment of this application, a reflection coefficient of an optical grating is changed by adjusting an absorption capability, to obtain an optimal signal-to-noise ratio. The absorption layer is located in the resonant cavity. Therefore, quantum efficiency of the absorption layer is improved by using an enhancement feature of the resonant cavity, and a thickness of the absorption layer is reduced. This is favorable for improving bandwidth, thereby improving receiver sensitivity of the signal light.

Optionally, in an implementation of the first aspect, the optical gain layer and the light absorption layer are disposed in parallel between the first reflection layer and the second reflection layer, and are parallel to the first reflection layer and the second reflection layer.

Optionally, in an implementation of the first aspect, an interlayer distribution sequence of the first reflection layer, the optical gain layer, the light absorption layer, and the second reflection layer in an incident direction of the signal light is:

the first reflection layer, the optical gain layer, the light absorption layer, and the second reflection layer; or
the first reflection layer, the light absorption layer, the optical gain layer, and the second reflection layer.

Optionally, in an implementation of the first aspect, the light absorption layer and the optical gain layer are separately perpendicular to the first reflection layer and the second reflection layer.

Optionally, in an implementation of the first aspect, the first reflection layer is disposed on one side of the light absorption layer, the optical gain layer is disposed on another side of the light absorption layer that is opposite to the side on which the first reflection layer is disposed, and the second reflection layer is disposed on another side of the optical gain layer that is opposite to a side on which the light absorption layer is disposed, where the light absorption layer and the optical gain layer are interfacially connected; or
the second reflection layer is disposed on one side of the light absorption layer, the optical gain layer is disposed on another side of the light absorption layer that is opposite to the side on which the second reflection layer is disposed, and the first reflection layer is disposed on another side of the optical gain layer that is opposite to a side on which the light absorption layer is disposed, where the light absorption layer and the optical gain layer are interfacially connected.

Optionally, in an implementation of the first aspect, the first reflection layer is disposed on one side of the optical gain layer, the second reflection layer is disposed on another side of the optical gain layer that is opposite to the side on which the first reflection layer is disposed, the first reflection layer is disposed on one side of the light absorption layer, and the second reflection layer is disposed on another side of the light absorption layer that is opposite to the side on which the first reflection layer is disposed, where the optical gain layer and the light absorption layer are interfacially connected and are parallel to each other.

Optionally, in an implementation of the first aspect, the first current source interface is a first P+ contact layer, the second voltage source interface is a second P+ contact layer, the second current source interface is a first N+ contact layer, and the first voltage source interface is a second N+ contact layer, where the first P+ contact layer, the second P+ contact layer, the first N+ contact layer, and the second N+ contact layer are parallel to each other;
the apparatus further includes an oxide isolation layer; and
the first P+ contact layer is disposed on one side of the optical gain layer, the first N+ contact layer is disposed on another side of the optical gain layer that is opposite to the side on which the first P+ contact layer is disposed, the second N+ contact layer is disposed on one side of the light absorption layer, the second P+ contact layer is disposed on another side of the light absorption layer that is opposite to the side on which the second N+ contact layer is disposed, and the oxide isolation layer is disposed in parallel between the first N+ contact layer and the second N+ contact layer, and is configured to isolate the first N+ contact layer from the second N+ contact layer; or
the first N+ contact layer is disposed on one side of the optical gain layer, the first P+ contact layer is disposed on another side of the optical gain layer that is opposite to the side on which the first N+ contact layer is disposed, the second P+ contact layer is disposed on one side of the light absorption layer, the second N+ contact layer is disposed on another side of the light absorption layer that is opposite to the side on which the second P+ contact layer is disposed, and the oxide isolation layer is disposed in parallel between the first P+ contact layer and the second P+ contact layer, and is configured to isolate the first P+ contact layer from the second P+ contact layer.

Optionally, in an implementation of the first aspect, the first current source interface is a first P+ contact layer, the second voltage source interface is a second P+ contact layer, the second current source interface is a first N+ contact layer, and the first voltage source interface is a second N+ contact layer, where the first P+ contact layer and the second P+ contact layer are located at a same layer, and the first N+ contact layer and the second N+ contact layer are interfacially connected and are located at a same layer;
the apparatus further includes an oxide isolation layer; and
the first N+ contact layer is disposed on one side of the optical gain layer, the first P+ contact layer is disposed on another side of the optical gain layer that is opposite to the side on which the first N+ contact layer is disposed, the second P+ contact layer is disposed on one side of the light absorption layer, the second N+ contact layer is disposed on another side of the light absorption layer that is opposite to the side on which the second P+ contact layer is disposed, and the oxide isolation layer is disposed in parallel between the first P+ contact layer and the second P+ contact layer, and is configured to isolate the first P+ contact layer from the second P+ contact layer.

Optionally, in an implementation of the first aspect, the oxide isolation layer is disposed between the first P+ contact layer and the second P+ contact layer, and is configured to isolate the first P+ contact layer from the second P+ contact layer. This prevents the first P+ contact layer and the second P+ contact layer from affecting each other, so that the current can be more stably supplied to the optical gain layer, and the voltage can be more stably supplied to the light absorption layer.

Optionally, in an implementation of the first aspect, the oxide isolation layer is disposed between the first N+ contact layer and the second N+ contact layer, and is configured to isolate the first N+ contact layer from the second N+ contact layer. This prevents the first N+ contact layer and the second N+ contact layer from affecting each other, so that the current can be more stably supplied to the optical gain layer, and the voltage can be more stably supplied to the light absorption layer.

Optionally, in an implementation of the first aspect, an evanescent field exists on a contact surface between the optical gain layer and the light absorption layer.

Optionally, in an implementation of the first aspect, the second current source interface and the first voltage source interface are integrated into a first public interface, and the first public interface is connected to both the negative electrode of the current source and the positive electrode of the voltage source.

Optionally, in an implementation of the first aspect, the first current source interface is a first P+ contact layer, the second voltage source interface is a second P+ contact layer, and the first public interface is an N+ contact layer, where the first P+ contact layer, the second P+ contact layer, and the N+ contact layer are parallel to each other; and the first P+ contact layer is disposed on one side of the optical gain layer, the N+ contact layer is disposed on another side of the optical gain layer that is opposite to the side on which the first P+ contact layer is disposed, the N+ contact layer is disposed on one side of the light absorption layer, and the second P+ contact layer is disposed on another side of the light absorption layer that is opposite to the side on which the N+ contact layer is disposed.

Optionally, in an implementation of the first aspect, the light absorption layer includes a single absorption structure or an absorption, grading, and multiplication SAGM structure of an avalanche photodetector APD.

Optionally, in an implementation of the first aspect, the optical gain layer and/or the light absorption layer are/is made of at least one of the following materials: a group III-V compound, silicon, germanium, and graphene, where the group III-V compound, the silicon, and the germanium are quantum wells and/or quantum dots.

Optionally, in an implementation of the first aspect, the first reflection layer and/or the second reflection layer include/includes at least one optical grating, and the first reflection layer and/or the second reflection layer reflect/reflects any one of the following forms of wavelengths: a single narrowband wavelength, a wavelength within one wavelength range, and a wavelength within a plurality of wavelength ranges.

Optionally, in an implementation of the first aspect, the apparatus further includes:

a substrate, connected to an outer side of the first reflection layer or an outer side of the second reflection layer, and configured to support the entire apparatus.

Optionally, the signal light may pass through the substrate without being affected by the substrate.

Optionally, the signal light may be incident on a front side of the optical-to-electrical conversion apparatus, or may be incident on a back side of the optical-to-electrical conversion apparatus. The front-side incidence means that the signal light is incident into the optical-to-electrical conversion apparatus from the first reflection layer, and exits from the substrate to enter an external link (where the substrate is connected to the outer side of the second reflection layer). The back-side incidence means that the signal light is incident into the optical-to-electrical conversion apparatus from the substrate, and exits from the second reflection layer to enter an external link (where the substrate is connected to the outer side of the first reflection layer).

According to a second aspect, the present invention provides an optical line terminal, including the optical-to-electrical conversion apparatus according to any one of the first aspect or the possible implementations of the first aspect.

According to the optical line terminal, a reflection coefficient of an optical grating is changed by adjusting an absorption capability, to obtain an optimal signal-to-noise ratio. An absorption layer is located in a resonant cavity. Therefore, quantum efficiency of the absorption layer is improved by using an enhancement feature of the resonant cavity, and a thickness of the absorption layer is reduced. This is favorable for improving bandwidth, thereby improving receiver sensitivity of signal light.

According to a third aspect, this application provides a communications system, including the optical-to-electrical conversion apparatus according to any one of the first aspect or the possible implementations of the first aspect, or including the optical line terminal according to the second aspect.

In the communications system, a reflection coefficient of an optical grating is changed by adjusting an absorption capability, to obtain an optimal signal-to-noise ratio. An absorption layer is located in a resonant cavity. Therefore, quantum efficiency of the absorption layer is improved by using an enhancement feature of the resonant cavity, and a thickness of the absorption layer is reduced. This is favorable for improving bandwidth, thereby improving receiver sensitivity of signal light.

According to a fourth aspect, this application provides a passive optical network PON system, including the optical line terminal according to the second aspect.

In the passive optical network PON system, a reflection coefficient of an optical grating is changed by adjusting an absorption capability, to obtain an optimal signal-to-noise ratio. An absorption layer is located in a resonant cavity. Therefore, quantum efficiency of the absorption layer is improved by using an enhancement feature of the resonant cavity, and a thickness of the absorption layer is reduced. This is favorable for improving bandwidth, thereby improving receiver sensitivity of signal light.

## BRIEF DESCRIPTION OF DRAWINGS

FIG 1 is a schematic diagram of a network architecture to which an embodiment of this application is applied;

FIG. 2 is a schematic structural diagram of an optical-to-electrical conversion apparatus according to an embodiment of this application;

FIG. 3 is a schematic structural diagram of an optical-to-electrical conversion apparatus according to an embodiment of this application;

FIG. 4 is a schematic structural diagram of an optical-to-electrical conversion apparatus according to an embodiment of this application;

FIG. 5 is a schematic structural diagram of an optical-to-electrical conversion apparatus according to an embodiment of this application;

FIG. 6 is a schematic structural diagram of an optical-to-electrical conversion apparatus according to an embodiment of this application;

FIG. 7 is a schematic structural diagram of an optical-to-electrical conversion apparatus according to an embodiment of this application;

FIG. 8 is a schematic structural diagram of an optical-to-electrical conversion apparatus according to an embodiment of this application;

FIG. 9 is a schematic structural diagram of an optical-to-electrical conversion apparatus according to an embodiment of this application;

FIG. 10 is a schematic structural diagram of an optical-to-electrical conversion apparatus according to an embodiment of this application;

FIG. 11 is a schematic structural diagram of an optical-to-electrical conversion apparatus according to an embodiment of this application;

FIG. 12 is a schematic structural diagram of an optical-to-electrical conversion apparatus according to an embodiment of this application; and

FIG. 13 is a schematic structural diagram of an optical line terminal according to an embodiment of this application.

## DESCRIPTION OF EMBODIMENTS

The following describes technical solutions in the embodiments of this application with reference to accompanying drawings.

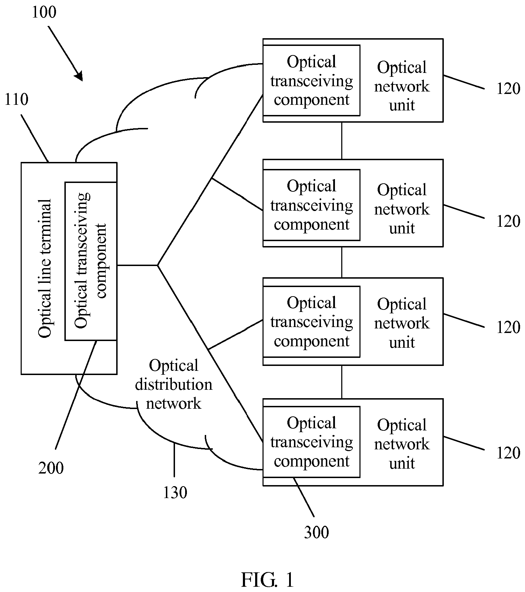

FIG. 1 is a schematic diagram of a network architecture to which an embodiment of this application is applied. The schematic diagram shows a network architecture of a PON system to which an optical signal generation apparatus provided in this application can be applied. The PON system 100 includes at least one optical line terminal (optical line terminal, OLT) 110, a plurality of optical network units (Optical Network Unit, ONU) 120, and an optical distribution network (Optical Distribution Network, ODN) 130. The optical line terminal 110 is connected to the plurality of optical network units 120 over the optical distribution network 130 in a point-to-multipoint manner. The optical line terminal 110 may communicate with the optical network units 120 by using a time division multiplexing (Time Division Multiplexing, TDM) mechanism, a wavelength division multiplexing (Wavelength Division Multiplexing, WDM) mechanism, or a TDM/WDM hybrid mechanism. A direction from the optical line terminal 110 to the optical network units 120 is defined as a downlink direction, and a direction from the optical network units 120 to the optical line terminal 110 is defined as an uplink direction.

The passive optical network system 100 may be a communications network for implementing data distribution between the optical line terminal 110 and the optical network units 120 without requiring any active component. In a specific embodiment, the data distribution between the optical line terminal 110 and the optical network units 120 may be implemented by using a passive optical component (for example, an optical splitter) in the optical distribution network 130. The passive optical network system 100 may be an asynchronous transfer mode passive optical network (ATM PON) or a broadband passive optical network (Broadband PON, BPON) system defined in the ITU-T G.983 standard, a GPON system defined in the ITU-T G.984 series standard, an EPON defined in the IEEE 802.3ah standard, a wavelength division multiplexing passive optical network (Wavelength Division Multiplexing PON, WDM-PON) system, or a next-generation passive optical network (an NGA PON system, for example, an XGPON system defined in the ITU-T G.987 series standard, a 10 G EPON system defined in the IEEE 802.3av standard, or a TDM/WDM hybrid PON system). The various passive optical network systems defined in the foregoing standards are incorporated in this application document by reference in their entireties.

The optical line terminal 110 is usually located in a central position, for example, a central office (Central Office, CO). The optical line terminal 110 can manage the plurality of optical network units 120 in a unified manner. The optical line terminal 110 can function as a medium between the optical network units 120 and an upper-layer network (not shown in the figure), forward data received from the upper-layer network to the optical network units 120 as downlink data, and forward uplink data received from the optical network units 120 to the upper-layer network. A specific structure configuration of the optical line terminal 110 may vary with a specific type of the passive optical network 100. In an embodiment, the optical line terminal 110 may include an optical transceiving component 200 and a data processing module (not shown in the figure). The optical transceiving component 200 may convert downlink data processed by the data processing module into downlink optical signals, send the downlink optical signals to the optical network units 120 over the optical distribution network 130, receive uplink optical signals that are sent by the optical network units 120 over the optical distribution network 130, convert the uplink data signals into electrical signals, and provide the electrical signals to the data processing module for processing.

The optical network units 120 may be disposed in user-side positions (for example, customer premises) in a distributed manner. The optical network units 120 may be network devices for communication between the optical line terminal 110 and a user. Specifically, the optical network units 120 may function as media between the optical line terminal 110 and the user. For example, the optical network units 120 may forward downlink data received from the optical line terminal 110 to the user, and forward data received from the user to the optical line terminal 110 as uplink data. Specific structure configurations of the optical network units 120 may vary with the specific type of the passive optical network 100. In an embodiment, the optical network units 120 may include optical transceiving components 300. The optical transceiving components 300 are configured to receive downlink data signals sent by the optical line terminal 110 over the optical distribution network 130, and send uplink data signals to the optical line terminal 110 over the optical distribution network 130.

The optical distribution network 130 may be a data distribution system, and may include an optical fiber, an optical coupler, an optical multiplexer/demultiplexer, an optical splitter, and/or another device. In an embodiment, the optical fiber, the optical coupler, the optical multiplexer/demultiplexer, the optical splitter, and/or the another device may be passive optical components or a passive optical component. Specifically, the optical fiber, the optical coupler, the optical multiplexer/demultiplexer, the optical splitter, and/or the another device may be components or a component that distribute or distributes data signals or a data signal between the optical line terminal 110 and the optical network unit 120 without power supply support. In addition, in another embodiment, the optical distribution network 130 may further include one or more processing devices, for example, an optical amplifier or a relay device (Relay device). In a branch structure shown in FIG. 1, the optical distribution network 130 may specifically extend from the optical line terminal 110 to the plurality of optical network units 120. However, the optical distribution network 130 may be alternatively configured to any other point-to-multipoint structure.

It should be understood that an optical-to-electrical conversion apparatus in an embodiment of this application may be applied to the foregoing PON system, and may be alternatively applied to another system. This application is not limited thereto.

It should be further understood that the optical line terminal and the optical network units in FIG. 1 include the optical transceiving components. The optical transceiving component may include the optical-to-electrical conversion apparatus in this application. The optical transceiving component includes a sending component and a receiving component. The sending component and the receiving component may be integrated. If the sending component is separated from the receiving component, the optical-to-electrical conversion apparatus in this application may be the receiving component, or the optical-to-electrical conversion apparatus in this application may be a part of the receiving component.

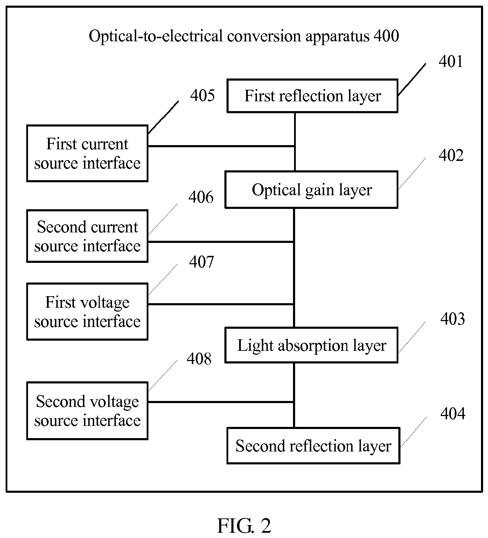

FIG. 2 is a schematic block diagram of an optical-to-electrical conversion apparatus 400 according to an embodiment of this application. The optical-to-electrical conversion apparatus in FIG. 2 may be applied to the PON system in FIG. 1. As shown in FIG. 2, the apparatus 400 includes:

a first reflection layer 401, an optical gain layer 402, a light absorption layer 403, a second reflection layer 404, a first current source interface 405, a second current source interface 406, a first voltage source interface 407, and a second voltage source interface 408.

The first reflection layer 401 and the second reflection layer 404 are disposed in parallel to form a resonant cavity between the first reflection layer 401 and the second reflection layer 404. Signal light is incident from the first reflection layer 401. After the signal light passes through the first reflection layer 401, signal light of a transmitted part is output to the resonant cavity. The signal light of the transmitted part is reflected for a plurality of times between the first reflection layer 401 and the second reflection layer 404, until the signal light in the resonant cavity is converted into a light current.

The optical gain layer 402 and the light absorption layer 403 are located in the resonant cavity.

The optical gain layer 402 is configured to amplify the signal light in the resonant cavity.

The light absorption layer 403 is configured to convert the signal light in the resonant cavity into the light current.

The first current source interface 405 and the second current source interface 406 are respectively connected to a positive electrode and a negative electrode of a current source, to supply a current to the optical gain layer 402.

The first voltage source interface 407 and the second voltage source interface 408 are respectively connected to a positive electrode and a negative electrode of a voltage source, to supply voltage to the light absorption layer.

It should be understood that the first reflection layer and the second reflection layer are disposed in parallel to form the resonant cavity between the first reflection layer and the second reflection layer.

It should be understood that the optical gain layer can operate only after externally connecting to the current source, and the light absorption layer can operate only after externally connecting to the voltage source.

Optionally, the first current source interface, the second current source interface, the first voltage source interface, and the second voltage source interface may be of a layered structure like the optical gain layer or the light absorption layer.

Optionally, the first current source interface, the second current source interface, the first voltage source interface, and the second voltage source interface have no impact on the signal light.

Optionally, a surface of the optical gain layer is a wafer disc, and a surface of the light absorption layer is a wafer disc.

Optionally, the first reflection layer may reflect a part of the incident signal light and transmit the other part of the incident signal light. A proportion of the signal light of the reflected part to the incident signal light and a proportion of the signal light of the transmitted part to the incident signal light are determined based on a reflectivity of the first reflection layer and/or a feature of the incident signal light, where the feature of the incident signal light may be a signal light wavelength, a signal light intensity, or the like. The first reflection layer may further reflect a part of the signal light in the resonant cavity and transmit a part of the signal light in the resonant cavity. A proportion of the signal light of the reflected part to the signal light in the resonant cavity and a proportion of the signal light of the transmitted part to the signal light in the resonant cavity are determined based on the reflectivity of the first reflection layer and/or a feature of the signal light in the resonant cavity, where the feature of the signal light in the resonant cavity may be a signal light wavelength, a signal light intensity, or the like. Similarly, the second reflection layer may reflect a part of the signal light in the resonant cavity and transmit a part of the signal light in the resonant cavity. A proportion of the signal light of the reflected part to the signal light in the resonant cavity and a proportion of the signal light of the transmitted part to the signal light in the resonant cavity are determined based on a reflectivity of the second reflection layer and/or the feature of the signal light in the resonant cavity, where the feature of the signal light in the resonant cavity may be the signal light wavelength, the signal light intensity, or the like.

Optionally, the light absorption layer converts some optical signals in the light absorption layer into a light current by using a photo-electric effect.

Optionally, the light absorption layer includes a single absorption structure or an absorption, grading, and multiplication (Separate Absorption, Grading, Charge, and Multiplication, SAGCM) structure of an avalanche photodetector (Avalanche Photodiode, APD).

Optionally, only an optical-to-electrical conversion phenomenon occurs in the light absorption layer that has the single absorption structure.

Optionally, both an optical-to-electrical conversion phenomenon and a phenomenon of avalanche multiplication of photo-generated carriers occur in the light absorption layer that has the absorption, grading, and multiplication structure of the avalanche photodetector.

Optionally, the optical gain layer and/or the light absorption layer are/is made of at least one of the following materials: a group III-V compound, silicon, germanium, and graphene, where the group III-V compound, the silicon, and the germanium are quantum wells and/or quantum dots.

Optionally, the first reflection layer and/or the second reflection layer include/includes at least one type of optical grating.

Optionally, the at least one type of optical grating may be one type of optical grating, may be a combination of a plurality of different types of optical gratings, or may be a combination of a plurality of optical gratings of a same type.

Optionally, a reflection coefficient of the optical grating may be changed by adjusting an absorption capability, to obtain an optimal signal-to-noise ratio.

Optionally, the first reflection layer and/or the second reflection layer reflect/reflects any one of the following forms of wavelengths: a single narrowband wavelength, a wavelength within one wavelength range, and a wavelength within a plurality of wavelength ranges.

Optionally, in the optical-to-electrical conversion apparatus 400 in this embodiment of this application, the light absorption layer and the voltage source that assists in supplying energy to the light absorption layer are added to an original structure of a vertical-cavity semiconductor optical amplifier (Vertical-cavity Semiconductor Optical Amplifier, VC-SOA). The light absorption layer interacts with an original structure in a cavity of the VC-SOA to directly convert the signal light into the light current in the optical-to-electrical conversion apparatus 400.

Therefore, in the optical-to-electrical conversion apparatus according to this embodiment of this application, the reflection coefficient of the optical grating is changed by adjusting the absorption capability, to obtain the optimal signal-to-noise ratio. The absorption layer is located in the resonant cavity. Therefore, quantum efficiency of the absorption layer is improved by using an enhancement feature of the resonant cavity, and a thickness of the absorption layer is reduced. This is favorable for improving bandwidth, thereby improving receiver sensitivity of the signal light.

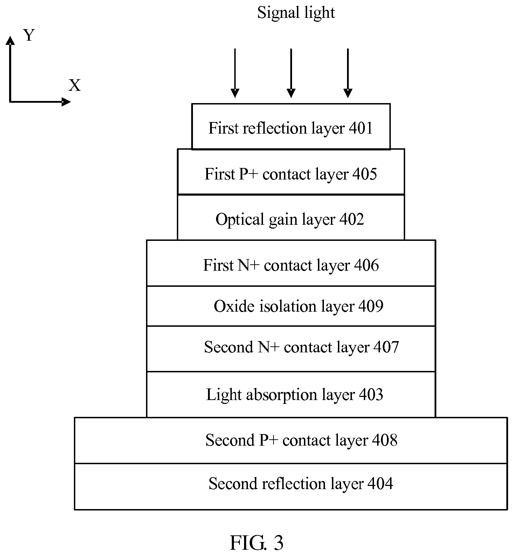

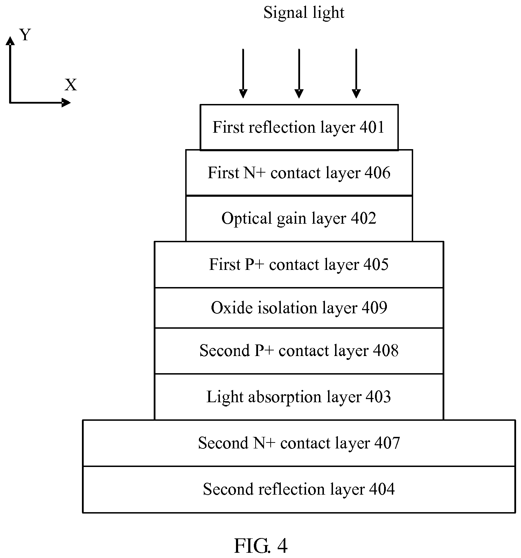

FIG. 3 and FIG. 4 are two schematic structural diagrams of the optical-to-electrical conversion apparatus according to the embodiment of this application.

As shown in FIG. 3 or FIG. 4, a two-dimensional coordinate system is established by using an incident direction of the signal light as a Y axis and using a direction perpendicular to the wafer disc of the optical gain layer 402 or to the wafer disc of the light absorption layer 403 as an X axis.

Optionally, as shown in FIG. 3, the optical gain layer 402 and the light absorption layer 403 are disposed in parallel between the first reflection layer 401 and the second reflection layer 404, and are parallel to the first reflection layer 401 and the second reflection layer 404.

Optionally, as shown in FIG. 3, an interlayer distribution sequence of the first reflection layer 401, the optical gain layer 402, the light absorption layer 403, and the second reflection layer 404 in the incident direction of the signal light is: the first reflection layer 401, the optical gain layer 402, the light absorption layer 403, and the second reflection layer 404.

Optionally, as shown in FIG. 3, the first current source interface 405 is a first P+ contact layer, the second voltage source interface 408 is a second P+ contact layer, the second current source interface 406 is a first N+ contact layer, and the first voltage source interface 407 is a second N+ contact layer, where the first P+ contact layer 405, the second P+ contact layer 408, the first N+ contact layer 406, and the second N+ contact layer 407 are parallel to each other.

Optionally, as shown in FIG. 3, the apparatus 400 further includes an oxide isolation layer 409.

The oxide isolation layer 409 may be disposed in parallel between the first N+ contact layer 406 and the second N+ contact layer 407, and is configured to isolate the first N+ contact layer 406 from the second N+ contact layer 407.

Optionally, as shown in FIG. 4, the oxide isolation layer 409 may be alternatively disposed in parallel between the first P+ contact layer 405 and the second P+ contact layer 408, and is configured to isolate the first P+ contact layer 405 from the second P+ contact layer 408.

Optionally, as shown in FIG. 3 or FIG. 4, the first P+ contact layer 405 is disposed on one side of the optical gain layer 402, the first N+ contact layer 406 is disposed on another side of the optical gain layer 402 that is opposite to the side on which the first P+ contact layer 405 is disposed, the second N+ contact layer 407 is disposed on one side of the light absorption layer 403, and the second P+ contact layer 408 is disposed on another side of the light absorption layer 403 that is opposite to the side on which the second N+ contact layer 407 is disposed.

Specifically, the signal light is incident from the first reflection layer 401. After the signal light passes through the first reflection layer 401, a part of transmitted signal light enters the resonant cavity. The signal light transmitted into the resonant cavity is first amplified in the optical gain layer 402, and is then partially converted into a light current in the light absorption layer 403. Signal light that is not converted into a light current enters the second reflection layer 404. After the signal light that is not converted into a light current passes through the second reflection layer 404, a part of reflected signal light re-enters the resonant cavity. The signal light reflected into the resonant cavity is first partially converted into a light current in the light absorption layer 403. A part of signal light that is not converted into a light current then enters the optical gain layer 402 and is amplified in the optical gain layer 402, and then re-enters the first reflection layer 401. After the amplified signal light passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

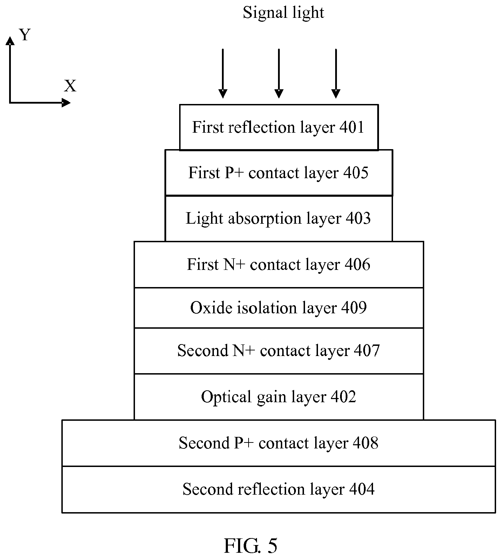

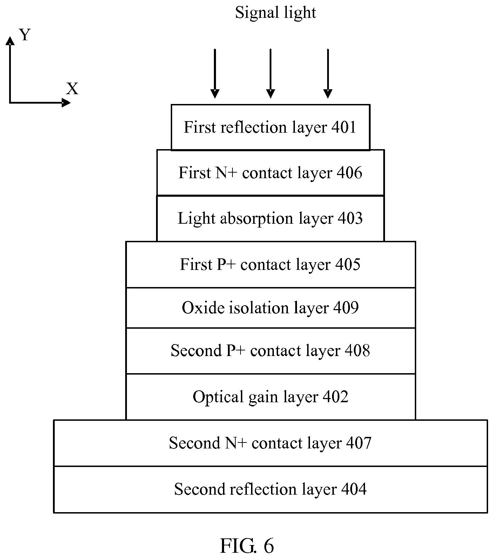

FIG. 5 and FIG. 6 are another two schematic structural diagrams of the optical-to-electrical conversion apparatus according to the embodiment of this application.

As shown in FIG. 5 or FIG. 6, a two-dimensional coordinate system is established by using an incident direction of the signal light as a Y axis and using a direction perpendicular to the wafer disc of the optical gain layer 402 or to the wafer disc of the light absorption layer 403 as an X axis.

Optionally, as shown in FIG. 5, the optical gain layer 402 and the light absorption layer 403 are disposed in parallel between the first reflection layer 401 and the second reflection layer 404, and are parallel to the first reflection layer 401 and the second reflection layer 404.

Optionally, as shown in FIG. 5, an interlayer distribution sequence of the first reflection layer 401, the optical gain layer 402, the light absorption layer 403, and the second reflection layer 404 in the incident direction of the signal light is: the first reflection layer 401, the light absorption layer 403, the optical gain layer 402, and the second reflection layer 404.

Optionally, as shown in FIG. 5, the first current source interface 405 is a first P+ contact layer, the second voltage source interface 408 is a second P+ contact layer, the second current source interface 406 is a first N+ contact layer, and the first voltage source interface 407 is a second N+ contact layer, where the first P+ contact layer 405, the second P+ contact layer 408, the first N+ contact layer 406, and the second N+ contact layer 407 are parallel to each other.

Optionally, as shown in FIG. 5, the apparatus further includes an oxide isolation layer 409.

The oxide isolation layer 409 may be disposed in parallel between the first P+ contact layer 405 and the second P+ contact layer 408, and is configured to isolate the first P+ contact layer 405 from the second P+ contact layer 408.

Optionally, as shown in FIG. 6, the oxide isolation layer 409 may be alternatively disposed in parallel between the first N+ contact layer 406 and the second N+ contact layer 407, and is configured to isolate the first N+ contact layer 406 from the second N+ contact layer 407.

Optionally, as shown in FIG. 5 or FIG. 6, the first P+ contact layer 405 is disposed on one side of the light absorption layer 403, the first N+ contact layer 406 is disposed on another side of the light absorption layer 403 that is opposite to the side on which the first P+ contact layer 405 is disposed, the second N+ contact layer 407 is disposed on one side of the optical gain layer 402, and the second P+ contact layer 408 is disposed on another side of the optical gain layer 402 that is opposite to the side on which the second N+ contact layer 407 is disposed.

Specifically, the signal light is incident from the first reflection layer 401. After the signal light passes through the first reflection layer 401, a part of transmitted signal light enters the resonant cavity. The signal light transmitted into the resonant cavity is first partially converted into a light current in the light absorption layer 403. Signal light that is not converted into a light current is amplified in the optical gain layer 402 and then enters the second reflection layer 404. After the amplified signal light passes through the second reflection layer 404, a part of reflected signal light re-enters the resonant cavity. The signal light reflected into the resonant cavity is first amplified in the optical gain layer 402 and then enters the light absorption layer 403 in which the signal light is partially converted into a light current. A part of signal light that is not converted into a light current then re-enters the first reflection layer 401. After the part of signal light that is not converted into a light current passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

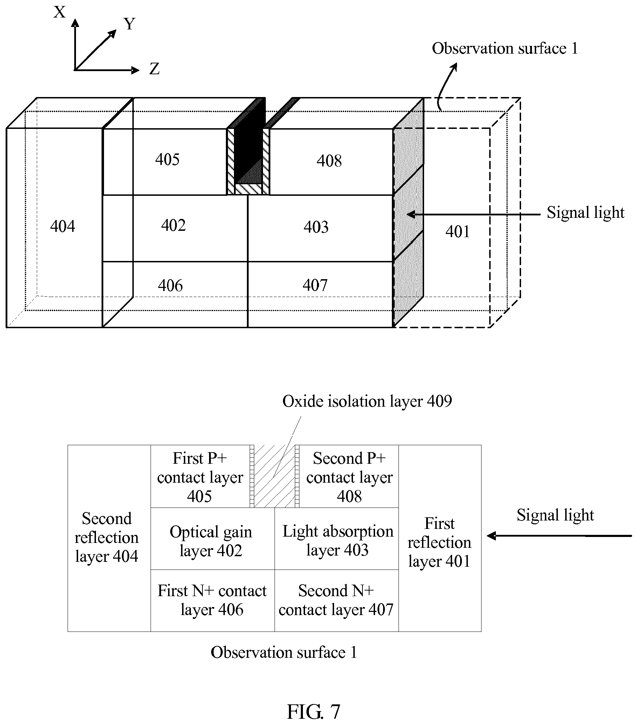

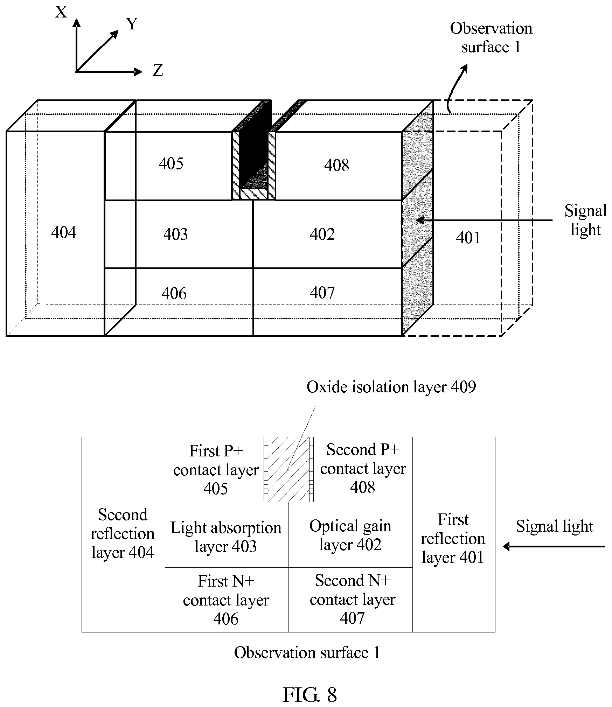

FIG. 7 and FIG. 8 are another two schematic structural diagrams of the optical-to-electrical conversion apparatus according to the embodiment of this application.

As shown in FIG. 7 or FIG. 8, a three-dimensional coordinate system is established by using an incident direction of the signal light as a Z axis, using a direction perpendicular to the wafer disc of the optical gain layer 402 or to the wafer disc of the light absorption layer 403 as an X axis, and using another direction as a Y axis.

Optionally, as shown in FIG. 7 or FIG. 8, the light absorption layer 403 and the optical gain layer 402 are separately perpendicular to the first reflection layer 401 and the second reflection layer 404.

Optionally, as shown in FIG. 7, the first reflection layer 401 is disposed on one side of the light absorption layer 403, the optical gain layer 402 is disposed on another side of the light absorption layer 403 that is opposite to the side on which the first reflection layer 401 is disposed, and the second reflection layer 404 is disposed on another side of the optical gain layer 402 that is opposite to a side on which the light absorption layer 403 is disposed, where the light absorption layer 403 and the optical gain layer 402 are interfacially connected.

Optionally, as shown in FIG. 8, the second reflection layer 404 is disposed on one side of the light absorption layer 403, the optical gain layer 402 is disposed on another side of the light absorption layer 403 that is opposite to the side on which the second reflection layer 404 is disposed, and the first reflection layer 401 is disposed on another side of the optical gain layer 402 that is opposite to a side on which the light absorption layer 403 is disposed, where the light absorption layer 403 and the optical gain layer 402 are interfacially connected.

Optionally, as shown in FIG. 7 or FIG. 8, the first current source interface 405 is a first P+ contact layer, the second voltage source interface 408 is a second P+ contact layer, the second current source interface 406 is a first N+ contact layer, and the first voltage source interface 407 is a second N+ contact layer, where the first P+ contact layer 405 and the second P+ contact layer 408 are located at a same layer, and the first N+ contact layer 406 and the second N+ contact layer 407 are interfacially connected and are located at a same layer.

Optionally, as shown in FIG. 7 or FIG. 8, the apparatus further includes an oxide isolation layer 409. The oxide isolation layer 409 is disposed in parallel between the first P+ contact layer 405 and the second P+ contact layer 408, and is configured to isolate the first P+ contact layer 405 from the second P+ contact layer 408.

Optionally, as shown in FIG. 7 or FIG. 8, the first N+ contact layer 406 is disposed on one side of the optical gain layer 402, the first P+ contact layer 405 is disposed on another side of the optical gain layer 402 that is opposite to the side on which the first N+ contact layer 406 is disposed, the second P+ contact layer 408 is disposed on one side of the light absorption layer 403, and the second N+ contact layer 407 is disposed on another side of the light absorption layer 403 that is opposite to the side on which the second P+ contact layer 408 is disposed.

Specifically, as shown in FIG. 7, the signal light is incident from the first reflection layer 401. After the signal light passes through the first reflection layer 401, a part of transmitted signal light enters the resonant cavity. The signal light transmitted into the resonant cavity is first partially converted into a light current in the light absorption layer 403. Signal light that is not converted into a light current is amplified in the optical gain layer 402 and then enters the second reflection layer 404. After the amplified signal light passes through the second reflection layer 404, a part of reflected signal light re-enters the resonant cavity. The signal light reflected into the resonant cavity is first amplified in the optical gain layer 402 and then enters the light absorption layer 403 in which the signal light is partially converted into a light current. A part of signal light that is not converted into a light current then re-enters the first reflection layer 401. After the part of signal light that is not converted into a light current passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

Specifically, as shown in FIG. 8, the signal light is incident from the first reflection layer 401. After the signal light passes through the first reflection layer 401, a part of transmitted signal light enters the resonant cavity. The signal light transmitted into the resonant cavity is first amplified in the optical gain layer 402, and is then partially converted into a light current in the light absorption layer 403. Signal light that is not converted into a light current enters the second reflection layer 404. After the signal light that is not converted into a light current passes through the second reflection layer 404, a part of reflected signal light re-enters the resonant cavity. The signal light reflected into the resonant cavity is first partially converted into a light current in the light absorption layer 403. A part of signal light that is not converted into a light current then enters the optical gain layer 402 and is amplified in the optical gain layer 402, and then re-enters the first reflection layer 401. After the amplified signal light passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

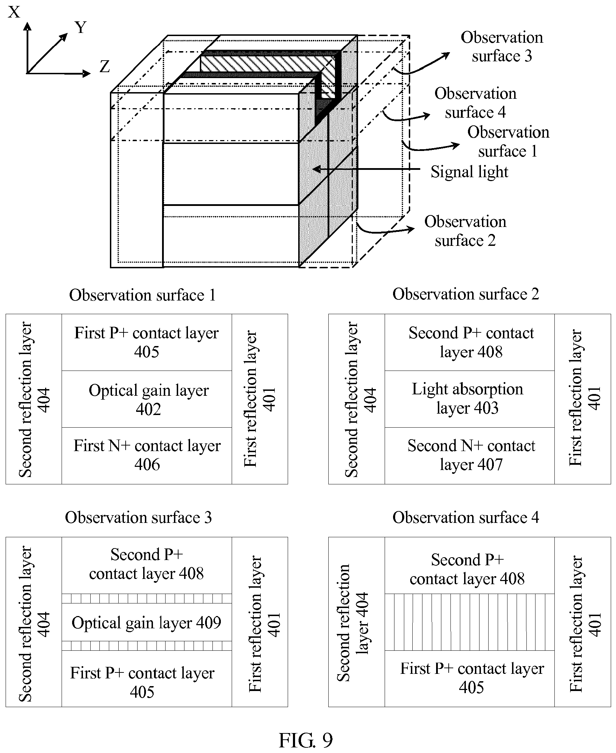

FIG. 9 is another schematic structural diagram of the optical-to-electrical conversion apparatus according to the embodiment of this application.

As shown in FIG. 9, a three-dimensional coordinate system is established by using an incident direction of the signal light as a Z axis, using a direction perpendicular to the wafer disc of the optical gain layer 402 or to the wafer disc of the light absorption layer 403 as an X axis, and using another direction as a Y axis.

Optionally, as shown in FIG. 9, the light absorption layer 403 and the optical gain layer 402 are separately perpendicular to the first reflection layer 401 and the second reflection layer 404.

Optionally, as shown in FIG. 9, the first reflection layer 401 is disposed on one side of the optical gain layer 402, the second reflection layer 404 is disposed on another side of the optical gain layer 402 that is opposite to the side on which the first reflection layer 401 is disposed, the first reflection layer 401 is disposed on one side of the light absorption layer 403, and the second reflection layer 404 is disposed on another side of the light absorption layer 403 that is opposite to the side on which the first reflection layer 401 is disposed, where the optical gain layer 402 and the light absorption layer 403 are interfacially connected and are parallel to each other.

Optionally, as shown in FIG. 9, the first current source interface 405 is a first P+ contact layer, the second voltage source interface 408 is a second P+ contact layer, the second current source interface 406 is a first N+ contact layer, and the first voltage source interface 407 is a second N+ contact layer, where the first P+ contact layer 405 and the second P+ contact layer 408 are located at a same layer, and the first N+ contact layer 406 and the second N+ contact layer 407 are interfacially connected and are located at a same layer.

Optionally, as shown in FIG. 9, the apparatus further includes an oxide isolation layer 409. The oxide isolation layer 409 is disposed in parallel between the first P+ contact layer 405 and the second P+ contact layer 408, and is configured to isolate the first P+ contact layer 405 from the second P+ contact layer 408.

Optionally, as shown in FIG. 9, the first N+ contact layer 406 is disposed on one side of the optical gain layer 402, the first P+ contact layer 405 is disposed on another side of the optical gain layer 402 that is opposite to the side on which the first N+ contact layer 406 is disposed, the second P+ contact layer 408 is disposed on one side of the light absorption layer 403, and the second N+ contact layer 407 is disposed on another side of the light absorption layer 403 that is opposite to the side on which the second P+ contact layer 408 is disposed.

Optionally, as shown in FIG. 9, an evanescent field exists on a contact surface between the optical gain layer 402 and the light absorption layer 403.

Optionally, after the signal light is incident from the first reflection layer 401, the signal light first enters the light absorption layer 403, then enters the optical gain layer 402, and then arrives at the second reflection layer 404. After the signal light passes through the second reflection layer 404, a part of reflected signal light re-enters the resonant cavity.

Specifically, the signal light is incident from the first reflection layer 401. After the signal light passes through the first reflection layer 401, a part of transmitted signal light enters the resonant cavity. The signal light transmitted into the resonant cavity is first partially converted into a light current in the light absorption layer 403. All signal light that is not converted into a light current is coupled into the optical gain layer 402 and is amplified in the optical gain layer 402, and then enters the second reflection layer 404. After the amplified signal light passes through the second reflection layer 404, a part of reflected signal light re-enters the resonant cavity. The signal light reflected into the resonant cavity is first amplified in the optical gain layer 402, then all coupled into the light absorption layer 403, and is partially converted into a light current in the light absorption layer 403. A part of signal light that is not converted into a light current then re-enters the first reflection layer 401. After the part of signal light that is not converted into a light current passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

Optionally, after the signal light is incident from the first reflection layer 401, the signal light first enters the optical gain layer 402, then enters the light absorption layer 403, and then arrives at the second reflection layer 404. After the signal light passes through the second reflection layer 404, a part of reflected signal light re-enters the resonant cavity.

Specifically, the signal light is incident from the first reflection layer 401. After the signal light passes through the first reflection layer 401, a part of transmitted signal light enters the resonant cavity. The signal light transmitted into the resonant cavity is first amplified in the optical gain layer 402, then all coupled into the light absorption layer 403, and partially converted into a light current in the light absorption layer 403. Signal light that is not converted into a light current enters the second reflection layer 404. After the signal light that is not converted into a light current passes through the second reflection layer 404, a part of reflected signal light re-enters the resonant cavity. The signal light reflected into the resonant cavity is first partially converted into a light current in the light absorption layer 403. A part of signal light that is not converted into a light current is then all coupled into the optical gain layer 402, is amplified in the optical gain layer 402, and then re-enters the first reflection layer 401. After the amplified signal light passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

Optionally, as shown in FIG. 3 to FIG. 9, the oxide isolation layer 409 may be disposed between the first P+ contact layer 405 and the second P+ contact layer 408, and is configured to isolate the first P+ contact layer 405 from the second P+ contact layer 408. This prevents the first P+ contact layer 405 and the second P+ contact layer 408 from affecting each other, so that the current can be more stably supplied to the optical gain layer 402, and the voltage can be more stably supplied to the light absorption layer 403. Optionally, the oxide isolation layer 409 may be alternatively disposed between the first N+ contact layer 406 and the second N+ contact layer 407, and is configured to isolate the first N+ contact layer 406 from the second N+ contact layer 407. This prevents the first N+ contact layer 406 and the second N+ contact layer 407 from affecting each other, so that the current can be more stably supplied to the optical gain layer 402, and the voltage can be more stably supplied to the light absorption layer 403.

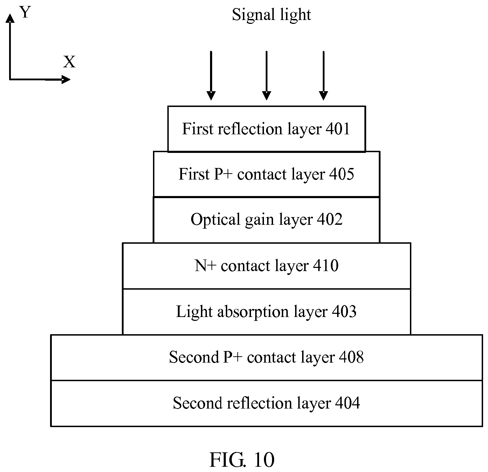

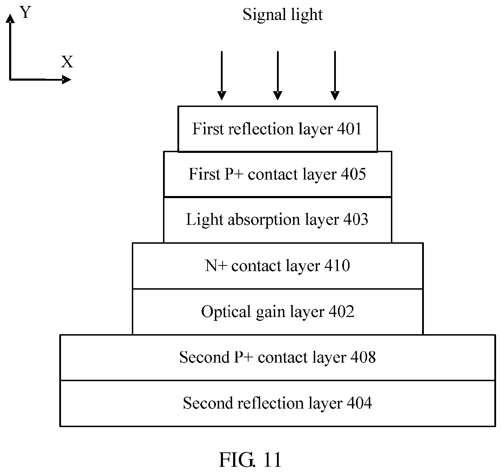

FIG. 10 and FIG. 11 are another two schematic structural diagrams of the optical-to-electrical conversion apparatus according to the embodiment of this application.

As shown in FIG. 10 or FIG. 11, a two-dimensional coordinate system is established by using an incident direction of the signal light as a Y axis and using a direction perpendicular to the wafer disc of the optical gain layer 402 or to the wafer disc of the light absorption layer 403 as an X axis.

Optionally, as shown in FIG. 10 or FIG. 11, the optical gain layer and the light absorption layer are disposed in parallel between the first reflection layer and the second reflection layer, and are parallel to the first reflection layer and the second reflection layer.

Optionally, as shown in FIG. 10, a spatial sequence of the first reflection layer 401, the optical gain layer 402, the light absorption layer 403, and the second reflection layer 404 in the incident direction of the signal light is: the first reflection layer 401, the optical gain layer 402, the light absorption layer 403, and the second reflection layer 404.

Optionally, as shown in FIG. 11, a spatial sequence of the first reflection layer 401, the optical gain layer 402, the light absorption layer 403, and the second reflection layer 404 in the incident direction of the signal light is: the first reflection layer 401, the light absorption layer 403, the optical gain layer 402, and the second reflection layer 404.

Optionally, as shown in FIG. 10 or FIG. 11, the second current source interface 406 and the first voltage source interface 406 are integrated into a first public interface 410. The first public interface 410 is connected to both the negative electrode of the current source and the positive electrode of the voltage source.

The first current source interface 405 is a first P+ contact layer, the second voltage source interface 408 is a second P+ contact layer, and the first public interface 410 is an N+ contact layer, where the first P+ contact layer 405, the second P+ contact layer 408, and the N+ contact layer 410 are parallel to each other.

Optionally, as shown in FIG. 10 or FIG. 11, the first P+ contact layer 405 is disposed on one side of the optical gain layer 402, the N+ contact layer 410 is disposed on another side of the optical gain layer 402 that is opposite to the side on which the first P+ contact layer 405 is disposed, the N+ contact layer 410 is disposed on one side of the light absorption layer 403, and the second P+ contact layer 408 is disposed on another side of the light absorption layer 403 that is opposite to the side on which the N+ contact layer 410 is disposed.

Specifically, as shown in FIG. 10, the signal light is incident from the first reflection layer 401. After the signal light passes through the first reflection layer 401, a part of transmitted signal light enters the resonant cavity. The signal light transmitted into the resonant cavity is first amplified in the optical gain layer 402, and is then partially converted into a light current in the light absorption layer 403. Signal light that is not converted into a light current enters the second reflection layer 404. After the signal light that is not converted into a light current passes through the second reflection layer 404, a part of reflected signal light re-enters the resonant cavity. The signal light reflected into the resonant cavity is first partially converted into a light current in the light absorption layer 403. A part of signal light that is not converted into a light current then enters the optical gain layer 402 and is amplified in the optical gain layer 402, and then re-enters the first reflection layer 401. After the amplified signal light passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

Specifically, as shown in FIG. 11, the signal light is incident from the first reflection layer 401. After the signal light passes through the first reflection layer 401, a part of transmitted signal light enters the resonant cavity. The signal light transmitted into the resonant cavity is first partially converted into a light current in the light absorption layer 403. Signal light that is not converted into a light current is amplified in the optical gain layer 402 and then enters the second reflection layer 404. After the amplified signal light passes through the second reflection layer 404, a part of reflected signal light re-enters the resonant cavity. The signal light reflected into the resonant cavity is first amplified in the optical gain layer 402 and then enters the light absorption layer 403 in which the signal light is partially converted into a light current. A part of signal light that is not converted into a light current then re-enters the first reflection layer 401. After the part of signal light that is not converted into a light current passes through the first reflection layer 401, a part of reflected signal light re-enters the resonant cavity. In this way, the signal light incident into the resonant cavity is reflected back and forth between the first reflection layer 401 and the second reflection layer 404, until the signal light in the resonant cavity is completely converted into a light current by the light absorption layer 403.

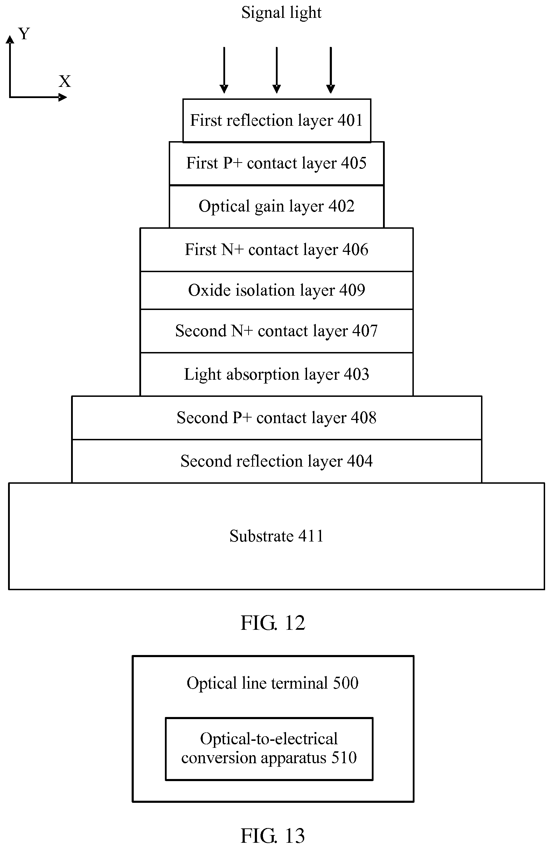

FIG. 12 is still another schematic structural diagram of the optical-to-electrical conversion apparatus according to the embodiment of this application.

As shown in FIG. 12, a two-dimensional coordinate system is established by using an incident direction of the signal light as a Y axis and using a direction perpendicular to the wafer disc of the optical gain layer 402 or to the wafer disc of the light absorption layer 403 as an X axis.

As shown in FIG. 12, the apparatus 400 further includes a substrate 411. The substrate 411 is connected to an outer side of the first reflection layer 401 or an outer side of the second reflection layer 404, and is configured to support the entire apparatus, where signal light may pass through the substrate 411.

Optionally, the signal light may pass through the substrate without being affected by the substrate.

Optionally, the signal light may be incident on a front side of the optical-to-electrical conversion apparatus 400, or may be incident on a back side of the optical-to-electrical conversion apparatus 400. The front-side incidence means that the signal light is incident into the optical-to-electrical conversion apparatus 400 from the first reflection layer 401, and exits from the substrate 411 to enter an external link (where the substrate 411 is connected to the outer side of the second reflection layer 404). The back-side incidence means that the signal light is incident into the optical-to-electrical conversion apparatus 400 from the substrate 411, and exits from the second reflection layer 404 to enter an external link (where the substrate 411 is connected to the outer side of the first reflection layer 401).

It should be understood that FIG. 12 is merely an example of the optical-to-electrical conversion apparatus 400 in the embodiments of this application, and the substrate 411 is added on a basis of FIG. 3. In the embodiments of this application, the substrate 411 may be alternatively added on a basis of FIG. 4 to FIG. 11.

Optionally, the apparatus 400 shown in FIG. 3, FIG. 4, FIG. 5, FIG. 6, FIG. 10, or FIG. 11 operates in a non-lasing state. In other words, the following formula 1 needs to be true:

$$\Gamma_x g < \alpha_i + \frac{1}{L}\ln\left(\frac{1}{r_1 r_2}\right) \quad \text{Formula 1}$$

In the formula 1, $\Gamma_x$ is a proportion of a part of the signal light that is located in the optical gain layer in an X direction to the total signal light, g is an optical gain of a unit length in the optical gain layer, $\alpha_i$ is an intra-cavity loss factor, L is a thickness of the optical gain layer, and $r_1$ and $r_2$ are intensity (intensity) reflection coefficients of a reflection layer 1 and a reflection layer 2 respectively.

Optionally, the apparatus 400 shown in FIG. 7, FIG. 8, or FIG. 9 operates in a non-lasing state. In other words, the following formula 2 needs to be true:

$$\Gamma_{xy} g < \alpha_i + \frac{1}{L}\ln\left(\frac{1}{r_1 r_2}\right) \quad \text{Formula 2}$$

In the formula, $\Gamma_{xy}$ is a proportion of a part of the signal light located in the optical gain layer in an X direction and a Y direction to the total signal light, g is an optical gain of a unit length in the optical gain layer, $\alpha_i$ is an intra-cavity loss factor, L is a length of the optical gain layer in a Z direction, and $r_1$ and $r_2$ are intensity (intensity) reflection coefficients of a reflection layer 1 and a reflection layer 2 respectively.

An embodiment of the present invention further proposes an optical line terminal. FIG. 13 is a schematic structural diagram of the optical line terminal. An optical line terminal 500 shown in FIG. 13 includes an optical-to-electrical conversion apparatus 510. The optical-to-electrical conversion apparatus 510 may be the optical-to-electrical conversion apparatus 400 shown in FIG. 2. For brevity, details are not described herein again.

It should be understood that the optical line terminal shown in FIG. 13 is merely an example. The optical line terminal in this embodiment of this application may further include other modules or units, for example, a MAC chip, include modules having functions similar to those of the modules in FIG. 13, or not necessarily include all the modules in FIG. 2.

In addition, an embodiment of this application further proposes a communications system. The communications system may include the optical-to-electrical conversion apparatus 400 shown in FIG. 2, or may include the optical line terminal 500 shown in FIG. 13. For brevity, details are not described herein again.

It should be understood that the communications system may further include other devices, apparatuses, or units, for example, may further include the ONUs shown in FIG. 1; or may include devices or modules having functions similar to those of the devices in FIG. 1.

In addition, an embodiment of this application further proposes a passive optical network PON system. The PON system includes the optical line terminal 500 shown in FIG. 13. For brevity, details are not described herein again.

It should be understood that the passive optical network PON system may further include other devices, apparatuses, or units, for example, may further include the ONUs shown in FIG. 1; or may include devices or modules having functions similar to those of the devices in FIG. 1.

It should be understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When functions are implemented in the form of a software functional unit and sold or used as an independent product, the functions may be stored in a computer readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, a network device, or the like) to perform all or some of the steps of the methods in the embodiments of the present invention. The foregoing storage medium includes any medium that can store program code, such as a USB flash drive, a removable hard disk, a read-only memory (ROM, Read-Only Memory), a random access memory (RAM, Random Access Memory), a magnetic disk, or an optical disc.

The foregoing descriptions are merely specific implementations of this application, but are not intended to limit the protection scope of this application. Any variation or replacement readily figured out by a person skilled in the art within the technical scope disclosed in the present invention shall fall within the protection scope of the present invention. Therefore, the protection scope of this application shall be subject to the protection scope of the claims.

## Claims

1.  An optical-to-electrical conversion apparatus, comprising a first reflection layer (401), an optical gain layer (402), a light absorption layer (403), a second reflection layer (404), a first current source interface (405), a second current source interface (406), a first voltage source interface (407), and a second voltage source interface (408), wherein

    the first reflection layer and the second reflection layer are disposed in parallel to form a resonant cavity between the first reflection layer and the second reflection layer; signal light is incident into the first reflection layer; after the signal light passes through the first reflection layer, signal light of a transmitted part is output to the resonant cavity; and the signal light of the transmitted part is reflected for a plurality of times between the first reflection layer and the second reflection layer, until the signal light in the resonant cavity is converted into a light current; the optical gain layer and the light absorption layer are located in the resonant cavity; the optical gain layer is configured to amplify the signal light in the resonant cavity; the light absorption layer is configured to convert the signal light in the resonant cavity into the light current; the first current source interface and the second current source interface are respectively connected to a positive electrode and a negative electrode of a current source, to supply a current to the optical gain layer; and the first voltage source interface and the second voltage source interface are respectively connected to a positive electrode and a negative electrode of a voltage source, to supply voltage to the light absorption layer.

2. The apparatus according to claim 1, wherein the optical gain layer and the light absorption layer are disposed in parallel between the first reflection layer and the second reflection layer, and are parallel to the first reflection layer and the second reflection layer.

3. The apparatus according to claim 2, wherein an interlayer distribution sequence of the first reflection layer, the optical gain layer, the light absorption layer, and the second reflection layer in an incident direction of the signal light is:

the first reflection layer, the optical gain layer, the light absorption layer, and the second reflection layer; or
the first reflection layer, the light absorption layer, the optical gain layer, and the second reflection layer.

4. The apparatus according to claim 1, wherein the light absorption layer and the optical gain layer are separately perpendicular to the first reflection layer and the second reflection layer.

5. The apparatus according to claim 4, wherein the first reflection layer is disposed on one side of the light absorption layer, the optical gain layer is disposed on another side of the light absorption layer that is opposite to the side on which the first reflection layer is disposed, and the second reflection layer is disposed on another side of the optical gain layer that is opposite to a side on which the light absorption layer is disposed, wherein the light absorption layer and the optical gain layer are interfacially connected; or
the second reflection layer is disposed on one side of the light absorption layer, the optical gain layer is disposed on another side of the light absorption layer that is opposite to the side on which the second reflection layer is disposed, and the first reflection layer is disposed on another side of the optical gain layer that is opposite to a side on which the light absorption layer is disposed, wherein the light absorption layer and the optical gain layer are interfacially connected.

6. The apparatus according to claim 4, wherein the first reflection layer is disposed on one side of the optical gain layer, the second reflection layer is disposed on another side of the optical gain layer that is opposite to the side on which the first reflection layer is disposed, the first reflection layer is disposed on one side of the light absorption layer, and the second reflection layer is disposed on another side of the light absorption layer that is opposite to the side on which the first reflection layer is disposed, wherein the optical gain layer and the light absorption layer are interfacially connected and are parallel to each other.

7. The apparatus according to claim 2 or 3, wherein the first current source interface is a first P+ contact layer, the second voltage source interface is a second P+ contact layer, the second current source interface is a first N+ contact layer, and the first voltage source interface is a second N+ contact layer, wherein the first P+ contact layer, the second P+ contact layer, the first N+ contact layer, and the second N+ contact layer are parallel to each other; the apparatus further comprises an oxide isolation layer; and the first P+ contact layer is disposed on one side of the optical gain layer, the first N+ contact layer is disposed on another side of the optical gain layer that is opposite to the side on which the first P+ contact layer is disposed, the second N+ contact layer is disposed on one side of the light absorption layer, the second P+ contact layer is disposed on another side of the light absorption layer that is opposite to the side on which second N+ contact layer is disposed, and the oxide isolation layer is disposed in parallel between the first N+ contact layer and the second N+ contact layer, and is configured to isolate the first N+ contact layer from the second N+ contact layer; or
the first N+ contact layer is disposed on one side of the optical gain layer, the first P+ contact layer is disposed on another side of the optical gain layer that is opposite to the side on which the first N+ contact layer is disposed, the second P+ contact layer is disposed on one side of the light absorption layer, the second N+ contact layer is disposed on another side of the light absorption layer that is opposite to the side on which the second P+ contact layer is disposed, and the oxide isolation layer is disposed in parallel between the first P+ contact layer and the second P+ contact layer, and is configured to isolate the first P+ contact layer from the second P+ contact layer.

8. The apparatus according to any one of claims 4 to 6, wherein the first current source interface is a first P+ contact layer, the second voltage source interface is a second P+ contact layer, the second current source interface is a first N+ contact layer, and the first voltage source interface is a second N+ contact layer, wherein the first P+ contact layer and the second P+ contact layer are located at a same layer, and the first N+ contact layer and the second N+ contact layer are interfacially connected and are located at a same layer; the apparatus further comprises an oxide isolation layer; and the first N+ contact layer is disposed on one side of the optical gain layer, the first P+ contact layer is disposed on another side of the optical gain layer that is opposite to the side on which the first N+ contact layer is disposed, the second P+ contact layer is disposed on one side of the light absorption layer, the second N+ contact layer is disposed on another side of the light absorption layer that is opposite to the side on which the second P+ contact layer is disposed, and the oxide isolation layer is disposed in parallel between the first P+ contact layer and the second P+ contact layer, and is configured to isolate the first P+ contact layer from the second P+ contact layer.

9. The apparatus according to claim 6, wherein an evanescent field exists on a contact surface between the optical gain layer and the light absorption layer.

10. The apparatus according to any one of claims 1 to 6, wherein the second current source interface and the first voltage source interface are integrated into a first public interface, and the first public interface is connected to both the negative electrode of the current source and the positive electrode of the voltage source.

11. The apparatus according to claim 10, wherein the first current source interface is a first P+ contact layer, the second voltage source interface is a second P+ contact layer, and the first public interface is an N+ contact layer, wherein the first P+ contact layer, the second P+ contact layer, and the N+ contact layer are parallel to each other; and the first P+ contact layer is disposed on one side of the optical gain layer, the N+ contact layer is disposed on another side of the optical gain layer that is opposite to the side on which the first P+ contact layer is disposed, the N+ contact layer is disposed on one side of the light absorption layer, and the second P+ contact layer is disposed on another side of the light absorption layer that is opposite to the side on which the N+ contact layer is disposed.

12. The apparatus according to any one of claims 1 to 11, wherein the light absorption layer consists of a single absorption structure or an absorption, grading, and multiplication SAGM structure of an avalanche photodetector APD.

13. The apparatus according to any one of claims 1 to 12, wherein the optical gain layer and/or the light absorption layer are/is made of at least one of the following materials: a group III-V compound, silicon, germanium, and graphene, wherein the group III-V compound, the silicon, and the germanium are quantum wells and/or quantum dots.

14. An optical line terminal, comprising the optical-to-electrical conversion apparatus according to any one of claims 1 to 13.

15. A passive optical network PON system, wherein the PON system comprises the optical line terminal according to claim 14.

**Patentansprüche**

1. Optisch-zu-elektrische Umwandlungsvorrichtung, umfassend eine erste Reflexionsschicht (401), eine optische Verstärkungsschicht (402), eine Lichtabsorptionsschicht (403), eine zweite Reflexionsschicht (404), eine erste Stromquellenschnittstelle (405), eine zweite Stromquellenschnittstelle (406), eine erste Spannungsquellenschnittstelle (407) und eine zweite Spannungsquellenschnittstelle (408), wobei
die erste Reflexionsschicht und die zweite Reflexionsschicht parallel angeordnet sind, um einen Resonanzhohlraum zwischen der ersten Reflexionsschicht und der zweiten Reflexionsschicht auszubilden; Signallicht in die erste Reflexionsschicht fällt; Signallicht eines übertragenen Teils in den Resonanzhohlraum ausgegeben wird, nachdem das Signallicht durch die erste Reflexionsschicht dringt; und das Signallicht des übertragenen Teils mehrfach zwischen der ersten Reflexionsschicht und der zweiten Reflexionsschicht reflektiert wird, bis das Signallicht in dem Resonanzhohlraum in einen Lichtstrom umgewandelt ist;
sich die optische Verstärkungsschicht und die Lichtabsorptionsschicht in dem Resonanzhohlraum befinden;
die optische Verstärkungsschicht dazu konfiguriert ist, das Signallicht in dem Resonanzhohlraum zu verstärken;

die Lichtabsorptionsschicht dazu konfiguriert ist, das Lichtsignal in dem Resonanzhohlraum in den Lichtstrom umzuwandeln;

die erste Stromquellenschnittstelle und die zweite Stromquellenschnittstelle jeweils mit einer positiven Elektrode und einer negativen Elektrode einer Stromquelle verbunden sind, um der optischen Verstärkungsschicht einen Strom zuzuführen; und

die erste Spannungsquellenschnittstelle und die zweite Spannungsquellenschnittstelle jeweils mit einer positiven Elektrode und einer negativen Elektrode einer Spannungsquelle verbunden sind, um der Lichtabsorptionsschicht Spannung zuzuführen.

2. Vorrichtung nach Anspruch 1, wobei die optische Verstärkungsschicht und die Lichtabsorptionsschicht parallel zwischen der ersten Reflexionsschicht und der zweiten Reflexionsschicht angeordnet sind und parallel zur ersten Reflexionsschicht und zur zweiten Reflexionsschicht liegen.

3. Die Vorrichtung nach Anspruch 2, wobei eine Sequenz der Zwischenschichtverteilung der ersten Reflexionsschicht, der optischen Verstärkungsschicht, der Lichtabsorptionsschicht und der zweiten Reflexionsschicht in einer Einfallrichtung des Signallichts Folgendes ist:

die erste Reflexionsschicht, die optische Verstärkungsschicht, die Lichtabsorptionsschicht und die zweite Reflexionsschicht; oder
die erste Reflexionsschicht, die Lichtabsorptionsschicht, die optische Verstärkungsschicht und die zweite Reflexionsschicht.

4. Vorrichtung nach Anspruch 1, wobei die Lichtabsorptionsschicht und die optische Verstärkungsschicht getrennt senkrecht zur ersten Reflexionsschicht und zur zweiten Reflexionsschicht liegen.

5. Vorrichtung nach Anspruch 4, wobei
die erste Reflexionsschicht auf einer Seite der Lichtabsorptionsschicht angeordnet ist, die optische Verstärkungsschicht auf einer anderen Seite der Lichtabsorptionsschicht angeordnet ist, die gegenüber der Seite liegt, auf welcher die erste Reflexionsschicht angeordnet ist, und die zweite Reflexionsschicht auf einer anderen Seite der optischen Verstärkungsschicht angeordnet ist, die gegenüber einer Seite liegt, auf welcher die Lichtabsorptionsschicht angeordnet ist, wobei die Lichtabsorptionsschicht und die optische Verstärkungsschicht grenzflächig verbunden sind; oder
die zweite Reflexionsschicht auf einer Seite der Lichtabsorptionsschicht angeordnet ist, die optische Verstärkungsschicht auf einer anderen Seite der Lichtabsorptionsschicht angeordnet ist, die gegenüber der Seite liegt, auf welcher die zweite Reflexionsschicht angeordnet ist, und die erste Reflexionsschicht auf einer anderen Seite der optischen Verstärkungsschicht angeordnet ist, die gegenüber einer Seite liegt, auf welcher die Lichtabsorptionsschicht angeordnet ist, wobei die Lichtabsorptionssicht und die optische Verstärkungsschicht grenzflächig verbunden sind.

6. Vorrichtung nach Anspruch 4, wobei
die erste Reflexionsschicht auf einer Seite der optischen Verstärkungsschicht angeordnet ist, die zweite Reflexionsschicht auf einer anderen Seite der optischen Verstärkungsschicht angeordnet ist, die gegenüber der Seite liegt, auf welcher die erste Reflexionsschicht angeordnet ist, die erste Reflexionsschicht auf einer Seite der Lichtabsorptionsschicht angeordnet ist und die zweite Reflexionsschicht auf einer anderen Seite der Lichtabsorptionsschicht angeordnet ist, die gegenüber der Seite liegt, auf welcher die erste Reflexionsschicht angeordnet ist, wobei die optische Verstärkungsschicht und die Lichtabsorptionsschicht grenzflächig verbunden sind und parallel zueinander liegen.

7. Vorrichtung nach Anspruch 2 oder 3, wobei die erste Stromquellenschnittstelle eine erste P+-Kontaktschicht ist, die zweite Spannungsquellenschnittstelle eine zweite P+-Kontaktschicht ist, die zweite Stromquellenschnittstelle eine erste N+-Kontaktschicht ist und die erste Spannungsquellenschnittstelle eine zweite N+-Kontaktschicht ist, wobei die erste P+-Kontaktschicht, die zweite P+-Kontaktschicht, die erste N+-Kontaktschicht und die zweite N+-Kontaktschicht parallel zueinander liegen;
die Vorrichtung ferner eine Oxidisolationsschicht umfasst; und
die erste P+-Kontaktschicht auf einer Seite der optischen Verstärkungsschicht angeordnet ist, die erste N+-Kontaktschicht auf einer anderen Seite der optischen Verstärkungsschicht angeordnet ist, die gegenüber der Seite liegt, auf welcher die erste P+-Kontaktschicht angeordnet ist, die zweite N+-Kontaktschicht auf einer Seite der Lichtabsorptionsschicht angeordnet ist, die zweite P+-Kontaktschicht auf einer anderen Seite der Lichtabsorptionsschicht angeordnet ist, die gegenüber der Seite liegt, auf welcher zweite N+-Kontaktschicht angeordnet ist, und die Oxidisolationsschicht parallel zwischen der ersten N+-Kontaktschicht und der zweiten N+-Kontaktschicht angeordnet ist und dazu konfiguriert ist, die erste N+-Kontaktschicht von der zweiten N+-Kontaktschicht zu isolieren; oder
die erste N+-Kontaktschicht auf einer Seite der optischen Verstärkungsschicht angeordnet ist, die erste P+-Kontaktschicht auf einer anderen Seite der optischen Verstärkungsschicht angeordnet ist, die gegenüber der Seite liegt, auf welcher die erste N+-Kontaktschicht angeordnet ist, die zweite P+-Kontaktschicht auf einer Seite der Lichtabsorptionsschicht angeordnet ist, die zweite N+-Kontaktschicht auf einer anderen Seite der Lichtabsorptionsschicht angeordnet ist, die gegenüber der Seite liegt, auf welcher die zweite P+-Kontaktschicht angeordnet ist, und die Oxidisolationsschicht parallel zwischen der ersten P+-Kontaktschicht und der zweiten P+-Kontaktschicht angeordnet ist und dazu konfiguriert ist, die erste P+-Kontaktschicht von der zweiten P+-Kontaktschicht zu isolieren.

8. Vorrichtung nach einem der Ansprüche 4 bis 6, wobei die erste Stromquellenschnittstelle eine erste P+-Kontaktschicht ist, die zweite Spannungsquellenschnittstelle eine zweite P+-Kontaktschicht ist, die zweite Stromquellenschnittstelle eine erste N+-Kontaktschicht ist und die erste Spannungsquellenschnittstelle eine zweite N+-Kontaktschicht ist, wobei sich die erste P+-Kontaktschicht und die zweite P+-Kontaktschicht auf einer gleichen Schicht befinden und die erste N+-Kontaktschicht und die zweite N+-Kontaktschicht grenzflächig verbunden sind und sich auf einer gleichen Schicht befinden;
die Vorrichtung ferner eine Oxidisolationsschicht umfasst; und
die erste N+-Kontaktschicht auf einer Seite der optischen Verstärkungsschicht angeordnet ist, die erste P+-Kontaktschicht auf einer anderen Seite der optischen Verstärkungsschicht angeordnet ist, die gegenüber der Seite liegt, auf welcher die erste N+-Kontaktschicht angeordnet ist, die zweite P+-Kontaktschicht auf einer Seite der Lichtabsorptionsschicht angeordnet ist, die zweite N+-Kontaktschicht auf einer anderen Seite der Lichtabsorptionsschicht angeordnet ist, die gegenüber der Seite liegt, auf welcher die zweite P+-Kontaktschicht angeordnet ist, und die Oxidisolationsschicht parallel zwischen der ersten P+-Kontaktschicht und der zweiten P+-Kontaktschicht angeordnet ist und dazu konfiguriert ist, die erste P+-Kontaktschicht von der zweiten P+-Kontaktschicht zu isolieren.

9. Vorrichtung nach Anspruch 6, wobei ein evaneszentes Feld an einer Kontaktfläche zwischen der optischen Verstärkungsschicht und der Lichtabsorptionsschicht besteht.

10. Vorrichtung nach einem der Ansprüche 1 bis 6, wobei die zweite Stromquellenschnittstelle und die erste Spannungsquellenschnittstelle in eine erste öffentliche Schnittstelle integriert sind und die erste öffentliche Schnittstelle sowohl mit der negativen Elektrode der Stromquelle als auch der positiven Elektrode der Spannungsquelle verbunden ist.

11. Vorrichtung nach Anspruch 10, wobei die erste Stromquellenschnittstelle eine erste P+-Kontaktschicht ist, die zweite Spannungsquellenschnittstelle eine zweite P+-Kontaktschicht ist und die erste öffentliche Schnittstelle eine N+-Kontaktschicht ist, wobei die erste P+-Kontaktschicht, die zweite P+-Kontaktschicht und die N+-Kontaktschicht parallel zueinander liegen; und die erste P+-Kontaktschicht auf einer Seite der optischen Verstärkungsschicht angeordnet ist, die N+-Kontaktschicht auf einer anderen Seite der optischen Verstärkungsschicht angeordnet ist, die gegenüber der Seite liegt, auf welcher die erste P+-Kontaktschicht angeordnet ist, die N+-Kontaktschicht auf einer Seite der Lichtabsorptionsschicht angeordnet ist und die zweite P+-Kontaktschicht auf einer anderen Seite der Lichtabsorptionsschicht angeordnet ist, die gegenüber der Seite liegt, auf welcher die N+-Kontaktschicht angeordnet ist.

12. Vorrichtung nach einem der Ansprüche 1 bis 11, wobei die Lichtabsorptionsschicht aus einer einzelnen Absorptionsstruktur oder einer Absorptions-, Einstufungs- und Multiplikations(SAGM)-Struktur eines Lawinen-Fotodetektors (APD) besteht.

13. Vorrichtung nach einem der Ansprüche 1 bis 12, wobei die optische Verstärkungsschicht und/oder die Lichtabsorptionsschicht aus mindestens einem der folgenden Materialien gefertigt sind/ist: eine Gruppe III-V-Verbindung, Silizium, Germanium und Graphen, wobei die Gruppe III-V-Verbindung, das Silizium und das Germanium Quantenmulden und/oder Quantenpunkte sind.

14. Optisches Leitungsendgerät, umfassend die optisch-zu-elektrische Umwandlungsvorrichtung nach einem der Ansprüche 1 bis 13.

15. Passives optisches Netzwerk(PON)-System, wobei das PON-System das optische Leitungsendgerät nach Anspruch 14 umfasst.

**Revendications**

1. Appareil de conversion optique-électrique, comprenant une première couche de réflexion (401), une couche de gain optique (402), une couche d'absorption de lumière (403), une seconde couche de réflexion (404), une première interface source de courant (405), une seconde interface source de courant (406), une première interface source de tension (407), et une seconde interface source de tension (408), dans lequel

la première couche de réflexion et la seconde couche de réflexion sont disposées en parallèle pour former une cavité résonante entre la première couche de réflexion et la seconde couche de réflexion ;

un signal lumineux est incident dans la première couche de réflexion ; après que le signal lumineux est passé à travers la première couche de réflexion, un signal lumineux d'une partie transmise est émis vers la cavité résonante ; et le signal lumineux de la partie transmise est réfléchi une pluralité de fois entre la première couche de réflexion et la seconde couche de réflexion, jusqu'à ce que le signal lumineux dans la cavité résonante soit converti en un photocourant ; la couche de gain optique et la couche d'absorption de lumière sont situées dans la cavité résonante ; la couche de gain optique est conçue pour amplifier le signal lumineux dans la cavité résonante ; la couche d'absorption de lumière est conçue pour convertir le signal lumineux dans la cavité résonante en photocourant ; la première interface source de courant et la seconde interface source de courant sont reliées respectivement à une électrode positive et une électrode négative d'une source de courant, pour fournir un courant à la couche de gain optique ; et la première interface source de tension et la seconde interface source de tension sont reliées respectivement à une électrode positive et une électrode négative d'une source de tension, pour fournir une tension à la couche d'absorption de lumière.

2. Appareil selon la revendication 1, dans lequel la couche de gain optique et la couche d'absorption de lumière sont disposées en parallèle entre la première couche de réflexion et la seconde couche de réflexion, et sont parallèles à la première couche de réflexion et la seconde couche de réflexion.

3. Appareil selon la revendication 2, dans lequel une séquence de distribution intercouche de la première couche de réflexion, de la couche de gain optique, de la couche d'absorption de lumière, et de la seconde couche de réflexion dans une direction incidente du signal lumineux est :

la première couche de réflexion, la couche de gain optique, la couche d'absorption de lumière, et la seconde couche de réflexion ; ou la première couche de réflexion, la couche d'absorption de lumière, la couche de gain optique, et la seconde couche de réflexion.

4. Appareil selon la revendication 1, dans lequel la couche d'absorption de lumière et la couche de gain optique sont perpendiculaires de manière séparée à la première couche de réflexion et la seconde couche de réflexion.

5. Appareil selon la revendication 4, dans lequel la première couche de réflexion est disposée sur un côté de la couche d'absorption de lumière, la couche de gain optique est disposée sur un autre côté de la couche d'absorption de lumière qui est opposé au côté sur lequel la première couche de réflexion est disposée, et la seconde couche de réflexion est disposée sur un autre côté de la couche de gain optique qui est opposé à un côté sur lequel la couche d'absorption de lumière est disposée, dans lequel la couche d'absorption de lumière et la couche de gain optique sont reliées de manière interfaciale ; ou la seconde couche de réflexion est disposée sur un côté de la couche d'absorption de lumière, la couche de gain optique est disposée sur un autre côté de la couche d'absorption de lumière qui est opposé au côté sur lequel la seconde couche de réflexion est disposée, et la première couche de réflexion est disposée sur un autre côté de la couche de gain optique qui est opposé à un côté sur lequel la couche d'absorption de lumière est disposée, dans lequel la couche d'absorption de lumière et la couche de gain optique sont reliées de manière interfaciale.

6. Appareil selon la revendication 4, dans lequel la première couche de réflexion est disposée sur un côté de la couche de gain optique, la seconde couche de réflexion est disposée sur un autre côté de la couche de gain optique qui est opposé au côté sur lequel la première couche de réflexion est disposée, la première couche de réflexion est disposée sur un côté de la couche d'absorption de lumière, et la seconde couche de réflexion est disposée sur un autre côté de la couche d'absorption de lumière qui est opposé au côté sur lequel la première couche de réflexion est disposée, dans lequel la couche de gain optique et la couche d'absorption de lumière sont reliées de manière interfaciale et sont parallèles l'une à l'autre.

7. Appareil selon la revendication 2 ou 3, dans lequel la première interface source de courant est une première couche de contact P+, la seconde interface source de tension est une seconde couche de contact P+, la seconde interface source de courant est une première couche de contact N+, et la première interface source de tension est une seconde couche de contact N+, dans lequel la première couche de contact P+, la seconde couche de contact P+, la première couche de contact N+, et la seconde couche de contact N+ sont parallèles les unes aux autres ; l'appareil comprend en outre une couche d'isolation d'oxyde ; et la première couche de contact P+ est disposée sur un côté de la couche de gain optique, la première couche de contact N+ est disposée sur un autre côté de la couche de gain optique qui est opposé au côté sur lequel la première couche de contact P+ est disposée, la seconde couche de contact N+ est disposée sur un côté de la couche d'absorption de lumière, la seconde couche de contact P+ est disposée sur un autre côté de la couche d'absorption de lumière qui est opposé au côté sur lequel une seconde couche de contact N+ est disposée, et la couche d'isolation d'oxyde est disposée en parallèle entre la première couche de contact N+ et la seconde couche de contact N+, et est conçue pour isoler la première couche de contact N+ de la seconde couche de contact N+ ; ou

la première couche de contact N+ est disposée sur un côté de la couche de gain optique, la première couche de contact P+ est disposée sur un autre côté de la couche de gain optique qui est opposé au côté sur lequel la première couche de contact N+ est disposée, la seconde couche de contact P+ est disposée sur un côté de la couche d'absorption de lumière, la seconde couche de contact N+ est disposée sur un autre côté de la couche d'absorption de lumière qui est opposé au côté sur lequel la seconde couche de contact P+ est disposée, et la couche d'isolation d'oxyde est disposée en parallèle entre la première couche de contact P+ et la seconde couche de contact P+, et est conçue pour isoler la première couche de contact P+ de la seconde couche de contact P+.

8. Appareil selon l'une quelconque des revendications 4 à 6, dans lequel la première interface source de courant est une première couche de contact P+, la seconde interface source de tension est une seconde couche de contact P+, la seconde interface source de courant est une première couche de contact N+, et la première interface source de tension est une seconde couche de contact N+, dans lequel la première couche de contact P+ et la seconde couche de contact P+ sont situées au niveau d'une même couche, et la première couche de contact N+ et la seconde couche de contact N+ sont reliées de manière interfaciale et sont situées au niveau d'une même couche ;

l'appareil comprend en outre une couche d'isolation d'oxyde ; et

la première couche de contact N+ est disposée sur un côté de la couche de gain optique, la première couche de contact P+ est disposée sur un autre côté de la couche de gain optique qui est opposé au côté sur lequel la première couche de contact N+ est disposée, la seconde couche de contact P+ est disposée sur un côté de la couche d'absorption de lumière, la seconde couche de contact N+ est disposée sur un autre côté de la couche d'absorption de lumière qui est opposé au côté sur lequel la seconde couche de contact P+ est disposée, et la couche d'isolation d'oxyde est disposée en parallèle entre la première couche de contact P+ et la seconde couche de contact P+, et est conçue pour isoler la première couche de contact P+ de la seconde couche de contact P+.

9. Appareil selon la revendication 6, dans lequel un champ évanescent existe sur une surface de contact entre la couche de gain optique et la couche d'absorption de lumière.

10. Appareil selon l'une quelconque des revendications 1 à 6, dans lequel la seconde interface source de courant et la première interface source de tension sont intégrées dans une première interface publique, et la première interface publique est reliée à la fois à l'électrode négative de la source de courant et l'électrode positive de la source de tension.

11. Appareil selon la revendication 10, dans lequel la première interface source de courant est une première couche de contact P+, la seconde interface source de tension est une seconde couche de contact P+, et la première interface publique est une couche de contact N+, dans lequel la première couche de contact P+, la seconde couche de contact P+, et la couche de contact N+ sont parallèles les unes aux autres ; et la première couche de contact P+ est disposée sur un côté de la couche de gain optique, la couche de contact N+ est disposée sur un autre côté de la couche de gain optique qui est opposé au côté sur lequel la première couche de contact P+ est disposée, la couche de contact N+ est disposée sur un côté de la couche d'absorption de lumière, et la seconde couche de contact P+ est disposée sur un autre côté de la couche d'absorption de lumière qui est opposé au côté sur lequel la couche de contact N+ est disposée.

12. Appareil selon l'une quelconque des revendications 1 à 11, dans lequel la couche d'absorption de lumière consiste en une seule structure d'absorption ou une structure SAGM d'absorption, de gradient, et de multiplication d'un photodétecteur à avalanche, APD.

13. Appareil selon l'une quelconque des revendications 1 à 12, dans lequel la couche de gain optique et/ou la couche d'absorption de lumière sont composées d'au moins un parmi les matériaux suivants : un composé du groupe III-V, du silicium, du germanium, et du graphène, dans lequel le composé du groupe III-V, le silicium, et le germanium sont des puits quantiques et/ou des boîtes quantiques.

14. Terminal de ligne optique, comprenant l'appareil de conversion optique-électrique selon l'une quelconque des revendications 1 à 13.

15. Système de réseau optique passif, PON, dans lequel le système PON comprend le terminal de ligne optique selon la revendication 14.

FIG. 1

FIG. 2

Signal light

Y

X

First reflection layer 401

First P+ contact layer 405

Optical gain layer 402

First N+ contact layer 406

Oxide isolation layer 409

Second N+ contact layer 407

Light absorption layer 403

Second P+ contact layer 408

Second reflection layer 404

FIG. 3

Signal light

Y

X

First reflection layer 401

First N+ contact layer 406

Optical gain layer 402

First P+ contact layer 405

Oxide isolation layer 409

Second P+ contact layer 408

Light absorption layer 403

Second N+ contact layer 407

Second reflection layer 404

FIG. 4

Signal light

Y

X

First reflection layer 401

First P+ contact layer 405

Light absorption layer 403

First N+ contact layer 406

Oxide isolation layer 409

Second N+ contact layer 407

Optical gain layer 402

Second P+ contact layer 408

Second reflection layer 404

FIG. 5

Signal light

Y

X

| First reflection layer 401 |
| First N+ contact layer 406 |
| Light absorption layer 403 |
| First P+ contact layer 405 |
| Oxide isolation layer 409 |
| Second P+ contact layer 408 |
| Optical gain layer 402 |
| Second N+ contact layer 407 |
| Second reflection layer 404 |

FIG. 6

| Second reflection layer 404 | First P+ contact layer 405 | Oxide isolation layer 409 | Second P+ contact layer 408 | First reflection layer 401 |
|---|---|---|---|---|
| | Optical gain layer 402 | | Light absorption layer 403 | |
| | First N+ contact layer 406 | | Second N+ contact layer 407 | |

Observation surface 1

FIG. 7

| | First P+ contact layer 405 | Oxide isolation layer 409 | Second P+ contact layer 408 | |
|---|---|---|---|---|
| Second reflection layer 404 | Light absorption layer 403 | | Optical gain layer 402 | First reflection layer 401 |
| | First N+ contact layer 406 | | Second N+ contact layer 407 | |

Signal light ←

Observation surface 1

FIG. 8

FIG. 9

Signal light

First reflection layer 401

First P+ contact layer 405

Optical gain layer 402

N+ contact layer 410

Light absorption layer 403

Second P+ contact layer 408

Second reflection layer 404

FIG. 10

Y

X

Signal light

First reflection layer 401

First P+ contact layer 405

Light absorption layer 403

N+ contact layer 410

Optical gain layer 402

Second P+ contact layer 408

Second reflection layer 404

FIG. 11

Signal light

Y
X

| First reflection layer 401 |
| First P+ contact layer 405 |
| Optical gain layer 402 |
| First N+ contact layer 406 |
| Oxide isolation layer 409 |
| Second N+ contact layer 407 |
| Light absorption layer 403 |
| Second P+ contact layer 408 |
| Second reflection layer 404 |
| Substrate 411 |

FIG. 12

Optical line terminal 500

Optical-to-electrical
conversion apparatus 510

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050230722 A

**Non-patent literature cited in the description**

- **YUYU XIA.** A vertical cavity semiconductor optical amplifier monolithically integrated with the photodetector. *Asia Communications and Photonics Conference,* 2016, AS1F.7

- **LEWEN.** Experimental demonstration of a multifunctional long-wavelength vertical cavity laser amplifier detector. *IEEE Photonics Technology Letters,* 1998, vol. 10 (8